Europäisches Patentamt

European Patent Office

Office européen des brevets

(19)

(11) Publication number: **0 118 921**
**A2**

# (12) EUROPEAN PATENT APPLICATION

(21) Application number: **84102742.8**

(22) Date of filing: **13.03.84**

(51) Int. Cl.³: **H 01 L 29/78**
**H 01 L 29/10**

(30) Priority: **14.03.83 JP 41934/83**

(43) Date of publication of application:
**19.09.84 Bulletin 84/38**

(84) Designated Contracting States:
**DE FR GB**

(71) Applicant: **NISSAN MOTOR COMPANY, LIMITED**
**No.2, Takara-cho, Kanagawa-ku**
**Yokohama-shi Kanagawa-ken 221(JP)**

(72) Inventor: **Akiyama, Wataru**
**7-14-13, Ohnodai**
**Sagamihara-shi Kanagawa-ken(JP)**

(72) Inventor: **Mihara, Teruyoshi**
**13-305, 1-16, Futaba**
**Yokosuka-shi Kanagawa-ken(JP)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) MOSFET with high density of integration and low on resistance.

(57) A vertical type MOSFET having a high degree of integration and a low ON resistance is shown. This device is formed so that the drain region has low resistivity part between well regions and the high resistivity part with which the bottoms of the well regions are in contact. Thereby provided is the MOSFET which has low ON resistance and a high breakdown voltage in spite of its high degree integration.

FIG. 2

EP 0 118 921 A2

## TITLE OF THE INVENTION

MOSFET WITH HIGH DENSITY OF INTEGRATION AND LOW ON RESISTANCE

## BACKGROUND OF THE INVENTION

This invention is related to a vertical type MOS field effect transistor (MOSFET) with a high density of integration and a low ON resistance.

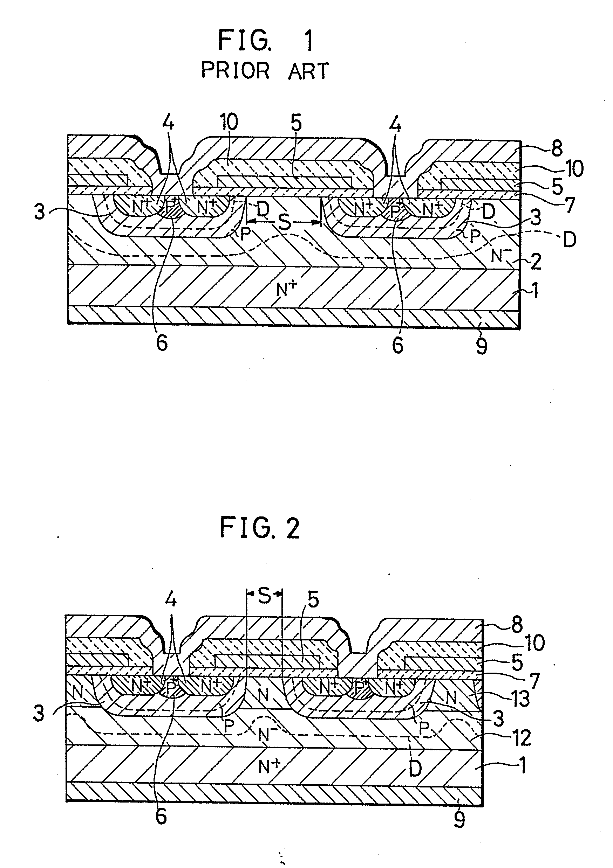

With reference to a cross-sectional view in FIG. 1, the configuration of an N-channel vertical type MOSFET as a prior art and some of the problems with it are described below.

This MOSFET consists of an N-type low resistivity drain region 1 ($N^+$ semiconductor substrate), a high resistivity drain region 2 ($N^-$ layer) which lies above it, P-type well regions 3 which are located in the upper half of this drain layer 2 and isolated from each other, and low resistivity N-type source regions 4 ($N^+$ regions) which lie within these well regions. The well region 3 performs the function of channel respectively.

The well regions 3 are separated by a distance S. In the centers of the well regions 3 there are P-type low resistivity well contact regions 6 ($P^+$ regions) which are in contact with the well regions 3. In addition, all of these regions except for the parts of the source regions 4 and the contact regions 6 in contact with a source electrodes 8 are covered by the silicon dioxide film 7. Formed on top of this silicon dioxide film 7 is a multi-crystalline silicon gate electrode 5 which spans the gaps between the neighboring well regions 3. This gate electrode, in turn, is covered by an insulation film 10 made of a material such as phosphorus glass.

The source electrode 8 covers this insulation film 10, which is deposited on top of the other layers by vacuum deposition and which contacts the source regions 4 and the well contact regions 6. Also, on the bottom surface of the drain region 1 a metallic drain electrode 9 is deposited by a similar process of vacuum deposition and makes contact with the drain substrate 1.

In FIG. 1, dotted line D indicates the limit of the depletion layer that is produced when the PN junction between the source and drain of this vertical type FET is reversely biased.

When a sufficient voltage is applied to the gate electrode

5, a channel region is formed in the well regions which lie below the gate electrode 5. Then when a voltage is applied to the drain electrode 9 with respect to the source electrode 8, an electric current flows from the drain electrode 9 to the drain region 2 through the drain substrate 1 and passes through the channel layer to the source regions 4 and the source electrode 8.

A MOSFET with this kind of configuration has really a wider area over which current is drawn than a so-called horizontal-type MOSFET, which has the source and drain electrodes on the same surface, making it more suitable as an element in applications where a large electric current must be handled. Also, sometimes the well regions 3 and source regions 4 are formed by double diffusion, with the gate electrode 5 as a mask, and because the concentration of impurities can be accurately controlled, the threshold in the operation of the MOSFET is accurate, without fluctuations.

However, in this kind of prior art vertical type MOSFET, a current flows in the high resistivity drain region confined between the well regions 3, so that there is a limit to how far the resistance during the time when a current is flowing between the source and the drain (to be referred to as ON resistance) can be reduced. That is to say, when the resistivity of the high resistivity drain region is reduced, a large electric field is produced at the junctions with the well regions 3, and the breakdown voltage between the source and the drain decreases. This causes the defect that there is a limit to how far the resistivity of this drain region 2 can be reduced.

Meanwhile, within the limit of the effective gate width, it is conceivable that the unit cell density could be increased to lower the ON resistance, but this would cause the region between the two well regions, labeled S in FIG. 1, to be narrowed still further, reducing the area through which the current can flow so that there would be no net reduction in the ON resistance.

Whether this ON resistance is large or small is a very important problem which affects the amount of heat given off by each semiconductor element, the limit to the density of elements
in the circuit imposed by this heat, the power consumption and
the reliability. In particular, in an element designed to handle
a large electric current it is important to reduce the ON
resistance as much as possible.

## SUMMARY OF THE INVENTION

An object of the invention is to provide a vertical-type
MOSFET which has a high density and a low ON resistance.

Another object of the invention is to provide vertical-type
MOSFET which has a high breakdown voltage in spite of its low ON
resistance.

These and other objects and advantages and effects are
accomplished by provision of a transistor in which the drain
region between the well regions is a region with low resistivity,
in order to reduce the resistance. In addition, between this
layer and the semiconductor substrate there is another layer with
a higher resistivity than that of the semiconductor substrate;
and the well regions are extended to this layer.

## BREIF DESCRIPTION OF THE DRAWINGS

FIG. 1 is a cross-sectional view showing a prior art
vertical-type N-channel MOSFET.

FIG. 2 is a cross-sectional view showing a first embodiment
according to the invention.

FIGS. 3(a) through (g) depict steps in the process by which
the transistor in FIG. 2 is produced.

FIG. 4 is a cross-sectional view showing a second embodiment
of vertical-type MOSFET according to the invention.

FIGS. 5(a) and (b) depict steps in the process by which the
transistor shown in FIG. 4 is produced.

## DETAILED DESCRIPTION OF THE PERFERRED EMBODIMENTS

Referring now paticularly to FIG. 2, a first embodiment of a
vetical-type MOSFET in accordance with the invention is shown.
Those letters and numerals which also appear in FIG. 1 have the
same meanings in both figures. Consequently, it is dispensed
with to describe them again here. The interval S between the well regions 3 is only half as great in FIG. 2 as in FIG. 1, but its ON resistance is nevertheless lower due to the configuration of the invention described detailedly hereinbelow.

First, described are the differences in configuration between the present MOSFET and the conventional type shown in FIG. 1. As can be seen in FIG. 2, above the drain substrate 1, which serves as a $N^+$ semiconductor substrate, there is a high resistivity drain region 12 (an $N^-$ region), which has a higher resistivity than this substrate, as the first drain region. Above it, as the second drain region, there is a low resistivity drain region 13 (an N region), with lower resistivity than this high resistivity drain region 12. Then, the well regions 3 are formed so that they penetrate more deeply than the low resistivity drain region 13, extending to the high resistivity region 12.

In FIG. 2, in the high resistivity drain region 12 and in the well regions 3, indicated with the dotted lines D are the limits of the depletion layer that is produced when the PN junction between the source and drain of this vertical type MOSFET is reversely biased.

That is to say, when a voltage is applied between the drain electrode and the source electrode, a reverse bias is created at the PN junction between the high resistivity drain region 12 and the well regions 3, and between the low resistivity drain region 13 and the well regions 3, thereby causing the depletion layers corresponding to each well regions 3 to expand and link up with each other and producing the situation shown in FIG. 2. Consequently, in this case the breakdown voltage is primarily determined in the lower parts of the well regions 3.

Next, a production process of the first embodiment of a MOSFET having the configuration described above will be described.

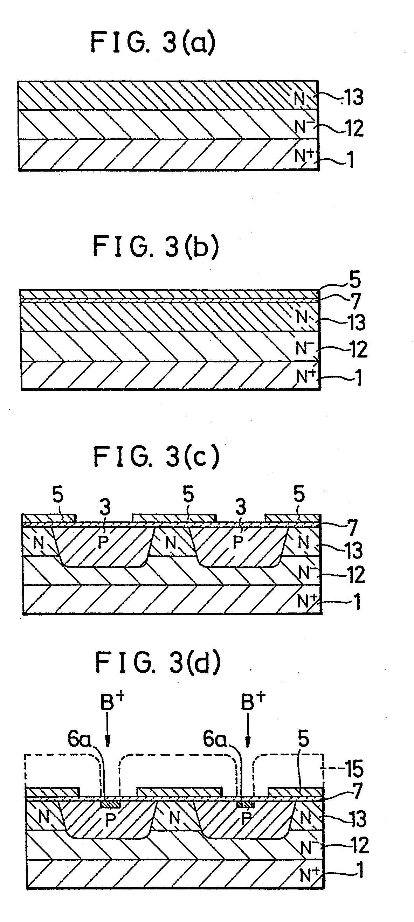

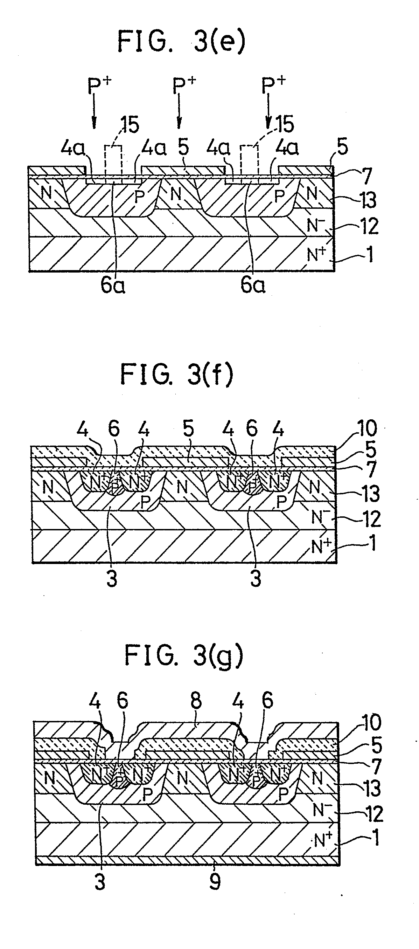

A specific example of such a production process is shown in FIG. 3 (a) through (g).

The first step is to prepare the low resistivity drain substrate 1 (the $N^+$ substrate) which is made up of N-type silicon monocrystalline having a donor impurity concentration $N_D$ of about $1\times10^{18}$ atoms/$cm^3$. Then, in this example, phosphene ($PH_3$) is introduced as an impurity gas and on the surface of this substrate 1 the high resistivity drain region ($N^-$ region) 12 having an $N_D$ on the order of $2\times10^{15}$ atoms/$cm^3$ and a thickness of about $10\mu m$ is epitaxially grown. After that the flow rate of phosphene is changed to cause epitaxial grouth of the low resistivity drain region (N region) 13, having an $N_D$ on the order of $5\times10^{15}$ atoms/$cm^3$ and a thickness of about $4\mu m$, on top of this epitaxially grown high resistivity drain region 12. The structure which results after these steps are completed is shown in FIG. 3(a).

The next step is to grow a silicon dioxide film 7 on top of the epitaxially grown low resistivity drain region 13 by means of thermal oxidation to a thickness of about 1000 Å. On the surface of this, silicon polycrystalline 5, to be used as the gate electrode, is grown to a thickness of about 4000Å by the CVD method. When this step has been completed the structure is as shown in the cross-sectional view in FIG. 3 (b).

The next step is to selectively remove this silicon polycrystalline layer 5 by photographic etching at the locations corresponding to the well regions 3. Then boron ions ($B^+$) are injected to a concentration of about $5\times10^{13}$ atoms/$cm^2$ by the ion implanation method. After that, the partly completed transistor is heat treated at about 1100 °C for 24 hours, causing simultaneous annealing and diffusion, thus producing the 4 to $6\mu$ m-thick well regions 3. After these steps have completed the structure is as shown in the cross-sectional view in FIG. 3 (c).

The next step is to cover all areas not corresponding to what will become the well contact regions with the photo resist shown by the dotted lines 15; then, with these as masks, boron ions ($B^+$) are injected to a concentration of about $5\times10^{15}$ atoms/$cm^2$ by the ion implantation. When these steps have been completed, the structure is as shown in the cross-sectional view in FIG. 3(d). The regions where boron ions have been injected are labeled 6a.

The next step is to remove the above-mentioned photoresist 15. Then the regions which are to become the well contact regions are covered by the photoresist 15 indicated by the dotted lines 15; with these as masks, phosphorus ions ($P^+$) are injected to a concentration of about $5 \times 10^{15}$ atoms/$cm^2$ by the ion implantation. When these steps have been complated the structure is as shown in the cross-sectional view in FIG. 3(e). The regions where the phosphorus ions have been injected are labeled 4a. The phosphorus ions also enter the silicon polycrystalline 5.

The next step is to remove the above-mentioned photoresist 15. Then the electrically insulating film 10 is formed to a thickness of about 7000Å, of phosphorus glass with a molar concentration ratio of about 3%, by the CVD method. Then the partially completed transistor is heat treated in nitrogen at about 1050°C, causing source regions 4 and well contact regions 6 to diffuse until they are about 1$\mu$m deep, simultaneously. When these steps have been completed the structure is as shown in the cross-sectional view in FIG. 3(f).

The next step is to form the contact for the gate electrodes, the common contact for the well regions 3 and the source region 4. To do this, windows are opened by etching and aluminum is vacuum-deposited on the surface to a thickness of about 1.5$\mu$m to form the source electrode 8 and the leading-out port for the gate electrode (not shown in Fig. 3(g)).

Then, the bottom of the drain substrate 1 is covered by a 1$\mu$m-thick coating of aluminum by vacuum deposition; then the bottom and the deposited coating are alloyed together at about 450°C to form the drain electrode 9. When this step has been completed the structure is as shown in the cross-sectional view in FIG. 3(g).

Thus, through the above process, the vertical type MOSFET structure shown in FIG. 2 can be produced.

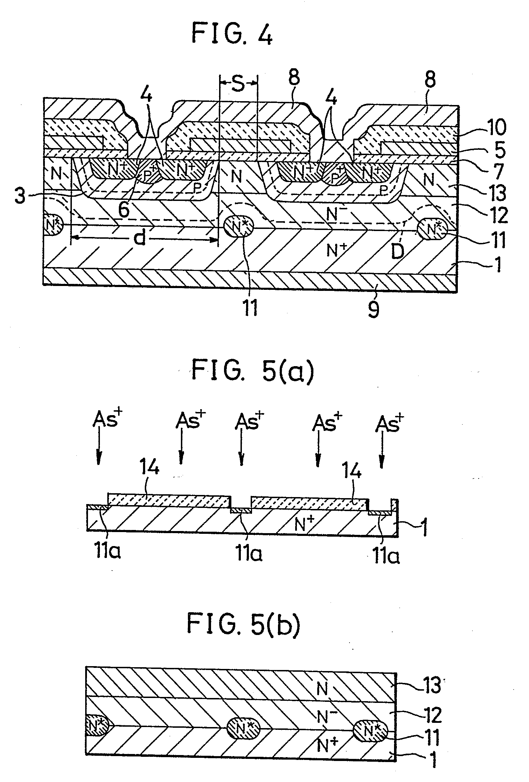

FIG. 4 shows a second embodiment of a transistor in accordance with the present invention. In this figure, those labels which are the same as labels used in FIG. 1 and FIG. 2 have the same meanings.

The transistor shown in FIG. 4 differs from the transistor shown in FIG. 2 in that it has the high-density N type (N*) buried regions 11 which span the boundary between the drain substrate 1 and the high resistivity drain region 12, which is the first drain region. These buried regions 11 are located between and outside of the well regions 3, corresponding to the low resistivity drain regions 13 which are the second drain regions.

In this case the depletion layer formed by a bias between the source electrode 8 and the drain electrode 9 is as shown by the dotted lines D. The size which the buried regions 11 can have is restricted by the condition that they must not contact the depletion layer. This condition prevents the buried regions 11 from causing a reduction in the breakdown voltage. In the embodiment shown here the size of the buried regions 11 can be controlled freely by varying their pattern and the amount of diffusion during the production process.

Thus, in the embodiment shown here, because of the presence of the buried regions 11, the electrical resistance of the pass through which electric current flows is decreased. Consequently, compared to the transistor shown in FIG. 2, the ON resistance is decreased even further.

Next, an example of production process by which the vertical type FET containing these buried regions can be produced will be described.

FIGS. 5(a) and (b) show a part of this production process. Since the remainder of the production process after the step shown in FIG. 5(b) coincides with the steps shown in FIGS. 3(b) through 3(g), the description are omitted here. Only those steps which differ from the process explained above with reference to FIG. 3 are described here.

The first step is to form the silicon dioxide film 14, about $1 \mu m$ thick, by thermal oxidation on the surface of the low resistivity drain substrate 1 which is formed from N-type silicon monocrystalline having a donor impurity concentration $N_D$ of about $1 \times 10^{18}$ atoms/$cm^3$. Next, this silicon dioxide film 14 is selectively removed by photographic etching at the locations corresponding to where the buried regions 11 are to be formed. Then arsenic ions ($As^+$) are injected to a concentration of about $1 \times 10^{16}$ ions/$cm^2$ by the ion implantation. When these steps have been completed, the structure is as shown in the cross-sectional view in FIG. 5(a). The regions where the arsenic ions have been injected are labeled 11a.

The next step is annealing, after which the silicon dioxide film 14 is removed. Then the high resistivity drain region 12 having an $N_D$ on the order of $2 \times 10^{15}$ atoms/$cm^3$ and a thickness of about $10 \mu m$ is grown epitaxially, for example, by introducing phosphene. Then the flow of phosphene is changed to grow the low resistivity drain region 13 having an $N_D$ on the order of $5 \times 10^{15}$ atoms/$cm^3$ and a thickness of about $4 \mu m$. At the same time, the buried regions 11 are formed by diffusion. When these steps have been completed, the structure is as shown in the cross-sectional view in FIG. 5(b).

The following steps are the same as those explained with reference to FIGS. 3 (b) through (g), eventually resulting in the vertical-type MOSFET having the structure shown in FIG. 4. The following are specific examples of the dimensions and impurity concentrations which such a transistor might have. The thicknesses of the $N^-$ regions 12 and the N region 13 are $10 \mu m$ and $4 \mu m$, respectively, and the width of the well regions 3 is 30 $\mu m$. The distance S between the well regions 3 is $5 \mu m$, about half of the corresponding distance in conventional types of MOSFET. The impurity concentrations of the $N^+$ region 1, the $N^-$ region 12 and the N region 13 are $1 \times 10^{18}$, $2 \times 10^{15}$ and $5 \times 10^{15}$ atoms/$cm^3$, respectively.

The well regions 3 penetrate about $1 \mu m$ into the high-

resistivity drain region 12, which is the first drain region.

When a voltage is applied between the source and the drain of an MOSFET having the structure described above, then, within the high resistivity drain region 12, the depletion layers are joined or link up with each other in the low resistivity drain regions 13 while the voltage rises to approximately 30 V, and expand into the part of the first drain region 12 just below the low resistivity drain regions 13. In this case, as in conventional types of transistor, the breakdown voltage is essentially determined in the lower parts of the well regions 3, and it comes out to be about 150V. Moreover, the ON resistance has been reduced to 1.25 ohm per square millimeter, even though the distance S between the well regions 3 has been reduced to only about half of what it was in conventional transistors. Also, by reducing the distance S between the well regions 3 to about half of what it was before, the unit cell density has been increased by about 25%.

Incidentally in the conventional MOSFET shown in FIG. 1, if the impurity concentration $N_D$ in the high resistivity drain region 2 is taken to be on the order of $2 \times 10^{15}$ atoms/cm$^3$, the thickness of the region 2 to be about 14 $\mu$m, the well regions 3 to be 30 $\mu$m wide and their diffusion has penetrated to a depth of 5 $\mu$m, and if the distance S between the well regions 3 is taken to be 10 $\mu$m, then breakdown voltage of about 150V is obtained, but the ON resistance is rather high, 1.5 ohms per square millimeter.

The practical examples as embodiments of the invention that have been given here are all N channel vertical-type MOSFETs, but it is clear that the N channel MOSFETS can be replaced by P channel MOSFETs in the above description. Also, the drain region has been split into two parts, a high resistivity region and a low resistivity region, but it is not necessary that it be split into only two parts; it could also be split into three or four parts.

The production processes which have been described in giving practical examples of how this invention could be used in transistors has involved the use of the ion implantation but it is possible to not use this method and to use, for example, the CVD method or the PVD method instead.

The values of resistivity given for the semiconductor layers in the above embodiments are merely examples; in a particular set of circumstances, different values could be used. The usefulness of this invention is not limited to the case in which the values given here are used.

As can be understood from the above description, since, in this invention, the drain region is divided into two parts, a high resistivity region and a low resistivity region, and since the low resistivity region is positioned between adjacent ones of the well regions, then even if the distance between the well regions is set on a small order, the ON resistance does not increase to an excessive value. In addition, since the bottoms of the well regions penetrate into the high resistivity region, there is no reduction in the breakdown voltage of the MOSFET, so that the unit cell density can be made high.

The effect of reducing the overall ON resistance is especially important in reducing the heating and power consumption of transistors to be used as elements in circuits which handle a large electric current.

What is claimed is:

1. A MOSFET with a high density of integration and a low ON resistance comprising:

a semiconductor substrate of a first conductivity type;

a first drain region of said first conductivity type formed on top of said semiconductor substrate;

a second drain region of said first conductivity type formed on top of said first drain region;

said second drain region has a lower resistivity than said first drain region;

well regions of the second conductivity type opposite to said first conductivity type;

said well region being adjacent to said second drain region and in contact with said first drain region at the bottom portions thereof;

source regions inside said well regions;

a drain electrode formed on the bottom surface of said semiconductor substrate;

gate electrodes formed through electrically insulating films on top of channels which are formed by the said well regions; and

at least one source electrode being in electrical contact with said source regions.

2. A MOSFET of claim 1, wherein said gate electrode spans said second drain region between adjacent ones of said well regions.

3. A MOSFET of claim 2, wherein said semiconductor substrate having a higher conductivity than that of said first drain region.

4. A MOSFET of claim 3, wherein the distance between adjacent ones of said well regions is at least less than $5 \mu$m.

5. A MOSFET of claim 3, further comprising well contact regions of said second conductivity type provided in the centers of said well regions and being in contact with said well regions and said source electrodes.

0118921

6. A MOSFET of claim 1, further comprising low resistivity buried regions of said first conductivity type which is located at the boundary between said substrate and said first drain region and between adjacent ones of said well region.

1/4

## FIG. 1
### PRIOR ART

## FIG. 2

0118921

## FIG. 3(a)

## FIG. 3(b)

## FIG. 3(c)

## FIG. 3(d)

## FIG. 3(e)

$P^+$   $P^+$   $P^+$

## FIG. 3(f)

## FIG. 3(g)

4/4

## FIG. 4

## FIG. 5(a)

## FIG. 5(b)